# EUROPEAN PATENT APPLICATION

(11) **EP 4 593 543 A1**
(43) Date of publication of application: **30.07.2025**
(21) Application number: 23868579.6
(22) Date of filing: 20.09.2023
(51) Int. Cl.: H05K 13/08, H05K 13/04, G01N 21/88

(54) **APPARATUS, METHOD, AND RECORDING MEDIUM FOR CONTROLLING SUBSTRATE PROCESSING PROCESS**

(30) Priority: 20.09.2022 KR 20220118808
(71) Applicant: Koh Young Technology Inc., Seoul 08588 (KR)
(72) Inventor: LEE, Jae Hwan, Seoul 04574 (KR); YOO, Yong Ho, Daejeon 34140 (KR); JUN, Bum Sue, Hwaseong-si Gyeonggi-do 18473 (KR); LEE, Ji Woon, Hwaseong-si Gyeonggi-do 18438 (KR); KANG, Jin Man, San Diego, CA 92129 (US)
(74) Representative: Meissner Bolte Partnerschaft mbB
(86) International application number: PCT/KR2023/014247
(87) International publication number: WO 2024/063527

(57) **Abstract**

A technique for controlling devices related to surface mount technology is provided. A device according to an embodiment of the present disclosure may include: a communication circuit; at least one processor; and at least one memory, wherein the at least one processor is configured to: obtain, first mounting result information resulting from measuring a state in which a component mounting device has mounted a target component on a target substrate, wherein the component mounting device includes a plurality of parts having a hierarchical relationship; determine whether at least one part of the parts is in an abnormal state, based on the first mounting result information and the hierarchical relationship, wherein the abnormal state indicates that the part does not satisfy predetermined criteria, and upon the determination that the part is in the abnormal state, control the measuring device to stop providing feedback to the component mounting device.

## Description

### TECHNICAL FIELD

The present disclosure relates to a technology for controlling a substrate processing process.

### BACKGROUND

A substrate processing process based on surface mount technology (SMT) may be performed on a substrate. The substrate processing process may include, for example, a process of printing solder on a substrate, a process of mounting a component on the solder printed on the substrate, and/or a process of solidifying the printed solder to bond the component to the substrate.

The state (e.g., position, direction, etc.) of a component that is ultimately bonded to a substrate may be influenced by various devices that perform the individual processes included in the substrate processing process. For example, the state of a component may be affected by a device for printing solder on a substrate, a device for mounting the component to the solder printed on the substrate, and a device for solidifying the solder. If the component that are ultimately bonded by the aforementioned devices do not make smooth contact with a pad (e.g., an electrode) on the substrate, it may result in defects in the substrate.

### SUMMARY

The present disclosure provides technology for controlling a substrate processing process.

A device according to an embodiment of the present disclosure may include: a communication circuit configured to communicate with a measuring device; at least one processor; and at least one memory storing commands to be executed by the at least one processor, wherein the at least one processor is configured to, when the commands are executed: obtain, from the measuring device, first mounting result information resulting from measuring a state in which a component mounting device has mounted a target component on a target substrate, wherein the component mounting device includes a plurality of parts having a hierarchical relationship; determine whether at least one part of the plurality of parts is in an abnormal state, based on the first mounting result information and the hierarchical relationship; and upon the determination that the at least one part is in the abnormal state, control the measuring device to stop providing feedback to the component mounting device, wherein the abnormal state indicates that the at least one part does not satisfy predetermined criteria.

In an embodiment, the at least one processor may be configured to control the measuring device to resume feedback in response to a signal indicating that the at least one part determined to be in the abnormal state is repaired.

In an embodiment, the at least one processor may be configured to transmit, to a user terminal, display information that enables a dashboard visualizing states of the plurality of parts to be displayed on the user terminal.

In an embodiment, the display information may include information about the at least one part, among the plurality of parts, which is determined to be in the abnormal state.

In an embodiment, the at least one processor may be configured to determine, based on the first mounting result information, an offset between a mounted state of the target component mounted on the target substrate and predetermined mounting criteria, and determine, based on the offset and the hierarchical relationship, that the at least one part is in the abnormal state.

In an embodiment, the offset may include at least one of a position offset between a mounting position of the target component and a mounting position indicated by the mounting criteria, and an angle offset between a mounting angle of the target component and a mounting angle indicated by the mounting criteria.

In an embodiment, the at least one processor may be configured to: obtain second mounting result information resulting from measuring a state in which components of the same type as the target component is mounted on a plurality of substrates each having a layout identical to a layout of the target substrate; determine, based on the second mounting result information, respective offsets of the components of the same type mounted on the plurality of substrates; and determine, based on an average of the offset of the target component and the respective offsets of the components of the same type, that the at least one part is in the abnormal state.

In an embodiment, the at least one processor may be configured to: obtain second mounting result information resulting from measuring a state in which components of the same type as the target component are mounted on a plurality of substrates each having a layout identical to a layout of the target substrate; determine, based on the second mounting result information, respective offsets of the components of the same type mounted on the plurality of substrates; and determine, based on a variance of the offset of the target component and the respective offsets of the components of the same type, that the at least one part is in the abnormal state.

In an embodiment, the at least one processor may be configured to: obtain third mounting result information resulting from measuring a state in which a first component and a second component distinct from the first component are mounted on the target substrate, the first component and the second component being mounted by one target part of the component mounting device; determine, based on the third mounting result information, an offset of the first component and an offset of the second component; and determine that the target part is in an abnormal state, based on the determination that the offset of the first component corresponds to the offset of the second component.

In an embodiment, the at least one memory may be further configured to store a machine learning model trained on a correlation between mounting result information and abnormal states of parts, and the at least one processor may be configured to determine, based on the machine learning model, that the at least one part is in the abnormal state.

According to an embodiment of the present disclosure, a method performed by a device may include: obtaining, from a measuring device, first mounting result information resulting from measuring a state in which a component mounting device has mounted a target component on a target substrate, the component mounting device includes a plurality of parts having a hierarchical relationship; determining whether at least one part of the plurality of parts is in an abnormal state based on the first mounting result information and the hierarchical relationship,; and upon the determination that the at least one part is in the abnormal state, controlling the measuring device to stop providing feedback to the component mounting device, wherein the abnormal state indicates that the at least one part does not satisfy predetermined criteria.

In an embodiment, the method may further include controlling the measuring device to resume the feedback in response to a signal indicating that the at least one part determined to be in the abnormal state is repaired.

In an embodiment, the method may further include transmitting, to a user terminal, display information that enables a dashboard visualizing states of the plurality of parts to be displayed on the user terminal.

In an embodiment, the display information may include information about a part, among the plurality of parts, which is determined to be in the abnormal state.

In an embodiment, the determining of the at least one of the plurality of parts to be in the abnormal state may include: determining, based on the first mounting result information, an offset between a mounted state of the target component mounted on the target substrate and predetermined mounting criteria; and determining, based on the offset and the hierarchical relationship, that the at least one part is in the abnormal state.

In an embodiment, the obtaining of the first mounting result information may include obtaining second mounting result information resulting from measuring a state in which components of the same type as the target component are mounted on a plurality of substrates each having a layout identical to a layout of the target substrate, the determining of the offset of the target component, based on the first mounting result information may include determining, based on the second mounting result information, respective offsets of the components of the same type mounted on the plurality of substrates, and the determining, based on the offset of the target component and the hierarchical relationship, that the at least one part is in the abnormal state may include determining, based on an average of the offset of the target component and the respective offsets of the components of the same type, that the at least one part is in the abnormal state.

In an embodiment, the obtaining of the first mounting result information may include obtaining second mounting result information resulting from measuring a state in which components of the same type as the target component are mounted on plurality of substrates each having a layout identical to a layout of the target substrate, the determining of the offset of the target component, based on the first mounting result information, may include determining, based on the second mounting result information, respective offsets of the components of the same type mounted on the plurality of substrates, and the determining, based on the offset of the target component and the hierarchical relationship, that the at least one part is in the abnormal state may include determining, based on a variance of the offset of the target component and the respective offsets of the components of the same type, that the at least one part is in the abnormal state.

In an embodiment, the obtaining of the first mounting result information may include obtaining third mounting result information resulting from measuring a state in which a first component and a second component distinct from the first component are mounted on the target substrate, the first component and the second component being mounted by one target part of the component mounting device, the determining of the offset of the target component, based on the first mounting result information, may include determining an offset of the first component and an offset of the second component based on the third mounting result information, and the determining, based on the offset of the target component and the hierarchical relationship, that the at least one part is in the abnormal state may include determining that the target part is in an abnormal state, based on determining that the offset of the first component corresponds to the offset of the second component.

In an embodiment, the determining of the at least one part to be in the abnormal state may include determining that the at least one part is in the abnormal state, based on a machine learning model trained on a correlation between mounting result information and abnormal states of parts.

According to an embodiment of the present disclosure, a non-transitory computer-readable recording medium may record a computer program to be executed by a processor, wherein the computer program is configured to cause the processor to perform one of the above-described methods when executed by the processor.

According to the present disclosure, it is possible to ensure smooth contact of a component with a pad of a substrate.

According to the present disclosure, it is possible to determine the state of parts constituting a device for mounting components related to surface mount technology (e.g., a component mounting device).

According to the present disclosure, a measuring device that measures the mounted state of a component may control feedback provided to the component mounting device.

According to the present disclosure, it is possible to visualize the states of the parts constituting the component mounting device.

Effects according to the technical ideas of the present disclosure are not limited to the above-described effects, and other effects not mentioned will be clearly understood by those skilled in the art to which the present disclosure belongs from the description in the specification.

### BRIEF DESCRIPTION OF DRAWINGS

FIG. 1 illustrates an environment in which devices according to an embodiment of the present disclosure may be applied.
FIGS. 2A and 2B illustrate a mounting process of a component mounting device that may be referred to in various embodiments of the present disclosure.
FIG. 3 illustrates a reference table that enables the mounting process described with reference to FIGS. 2A and 2B to be performed.
FIG. 4 illustrates a hierarchical relationship of parts of a component mounting device, which may be referred to in various embodiments of the present disclosure.
FIG. 5 illustrates a computing device capable of implementing devices according to an embodiment of the present disclosure.
FIG. 6 illustrates a flowchart showing a method according to an embodiment of the present disclosure.
FIGS. 7 and 8 illustrate flowcharts showing operations of determining an abnormal state according to an embodiment of the present disclosure.
FIGS. 9 to 18C illustrate types of abnormal states of a component mounting device and mounting results based on the types of abnormal states, which may be referred to in various embodiments of the present disclosure.
FIG. 19 illustrates a machine learning model which may be referred to in various embodiments of the present disclosure.
FIG. 20 illustrates a flowchart showing a method according to an embodiment of the present disclosure.
FIGS. 21 and 22 illustrate dashboards which may be referred to in various embodiments of the present disclosure.

### DETAILED DESCRIPTION

Various embodiments described in the present disclosure are exemplified for the purpose of clearly explaining the technical idea of the present disclosure, and are not intended to limit the present disclosure to specific embodiments. The technical idea of the present disclosure includes various modifications, equivalents, and alternatives of each embodiment described in the present disclosure, and embodiments selectively combined from all or a part of each embodiment. In addition, the scope of the technical idea of the present disclosure is not limited to various embodiments presented below or detailed description thereof.

All terms used in the present disclosure, including technical or scientific terms, have meanings that are generally understood by those skilled in the art to which the present disclosure pertains, unless otherwise defined.

Expressions used in the present disclosure, such as "include", "may include", "provided with", "may be provided with", "have", "may have", etc., imply that target features (e.g., a function, an operation, or an element) are present, and do not exclude the presence of other additional features. That is, such expressions should be understood as open-ended terms connoting the possibility of inclusion of other embodiments.

A singular expression used in the present disclosure may include meanings of plurality, unless otherwise mentioned in the context, and this is also applicable to a singular expression stated in the claims.

The expression such as "a first", "a second", "first", or "second" used in the present disclosure is used to distinguish one object from another object in referring to a plurality of homogeneous objects, unless the context dictates otherwise, and does not limit the order or the importance between the objects.

Expressions, such as "A, B, and C", "A, B, or C", "at least one of A, B, and C", or "at least one of A, B, or C", used in the present disclosure, may imply each listed item or all possible combinations of listed items. For example, "at least one of A or B" may refer to all of (1) at least one A, (2) at least one B, and (3) at least one A and at least one B.

The expression "based on" used in the present disclosure is used to describe one or more factors that influence a decision, an action of judgment, or an operation described in a phrase or a sentence including the relevant expression, and this expression does not exclude an additional factor influencing the decision, the action of judgment, or the operation.

Herein, when an element (e.g., a first element) is expressed as being "coupled" or "connected" to another element (a second element), the element may be coupled or connected directly to the other element, or may be coupled or connected to the other element via another new element (e.g., a third element).

The expression "configured to" used in the present disclosure may imply "designed to", "having the capacity to", "adapted to", "made to", "capable of", etc. according to the context. This expression is not limited to implying "specifically designed to" in hardware. For example, a processor configured to perform a specific operation may imply a generic purpose processor capable of performing the specific operation by executing software, or may imply a specialpurpose computer structured through programming to perform the specific operation.

As used in the present disclosure, the term "substrate" refers to a plate or container on which elements such as semiconductor chips are mounted, which may be formed from a material such as silicon and may serve as a connection passage for electrical signals between the elements. A substrate may be used to fabricate an integrated circuit. For example, a substrate may be a printed circuit board (PCB), a wafer, or the like.

As used in the present disclosure, the term "component" may refer to an element that is mounted on a substrate. Such components may also be referred to interchangeably as, for example, parts or packages.

As used in the present disclosure, the term "user interface (UI)" may refer to a physical or virtual medium made to enable communication between a user and an object, a system, a machine, or a computer program. According to the present disclosure, for example, a user may identify and/or select various types of information about a substrate processing process through a user interface provided to a user terminal by a control device that provides overall management and control of the substrate processing process according to surface mount technology.

As used in the present disclosure, the term "machine learning (ML)" may refer to a technique for training a machine learning model to classify, analyze, and/or predict features of input data. That is, machine learning may refer to the process of training a machine learning model through experience in processing input data as training data. Machine learning may include a technology that enable machine learning models to mimic human learning, reasoning, and/or perceptual capabilities, for example, a technology such as artificial intelligence or symbolic logic. The machine learning may be applied in technical fields such as linguistic understanding, visual understanding, reasoning, prediction, knowledge representation, or operation control.

As used in the present disclosure, the term "machine learning model" may be an outcome that is generated through machine learning. Specifically, a machine learning model may be constructed by modeling a correlation between pieces of input data, wherein the correlation may be represented by at least one parameter. Here, the machine learning model may extract at least one feature from the input data and analyze the feature to derive a correlation between the pieces of input data in a manner intended by machine learning, and may optimize the parameters by repeating this process. For example, a machine learning model may learn mapping (e.g., correlation) between input and output with respect to data given data as input-output pairs (e.g., supervised learning). In another example, even when only input data is provided, a machine learning model may also learn relationships between pieces of the input data by deriving regularity between the pieces of the given data (e.g., unsupervised learning). As a result of optimizing/constructing parameters, the machine learning model may classify, analyze, and/or predict features of the input data to produce output data, as intended in machine learning. The machine learning model may also be referred to as an artificial intelligence model or a neural network model.

In relation to the structure of a machine learning model, the machine learning model may be designed to implement the structure of a human brain on a computer. That is, a machine learning model may include multiple network nodes that simulate neurons in a human neural network. Each of the multiple network nodes may simulate the synaptic activity of neurons, in which the neurons exchange signals through synapses, and may have connection relationships with other nodes. Specifically, in the machine learning model, the multiple network nodes may be located on layers with different depths and may exchange based on, for example, convolutional connections.

Hereinafter, various embodiments of the present disclosure will be described with reference to the accompanying drawings. In the accompanying drawings and the description of the drawings, identical or substantially equivalent elements may be given the same reference numerals. Furthermore, in the following description of various embodiments, redundant descriptions of the same or corresponding elements may be omitted, but this does not imply that the elements are not included in the embodiments.

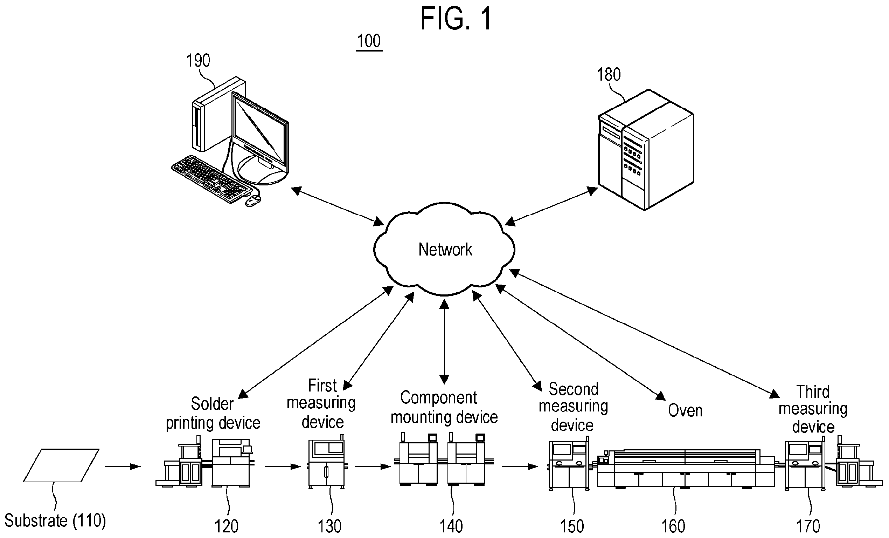

FIG. 1 illustrates an environment 100 in which devices 120, 130, 140, 150, 160, 170, 180, and 190 according to an embodiment of the present disclosure may be applied. The environment 100 described with reference to FIG. 1 relates to an environment in which a control device 180 manages and controls the devices 120, 130, 140, 150, 160, and 170 related to a surface mount technology, or substrate processing processes performed by the devices 120, 130, 140, 150, 160, and 170. Furthermore, the environment 100 illustrated in FIG. 1 relates to an environment in which the control device 180 transmits various types of information regarding a substrate processing process to the user terminal 190 via a user interface, or obtains a response to the various types of information from the user terminal 190.

FIG. 1 illustrates the environment 100 in which a single user terminal 190 and a pair of devices 120, 130, 140, 150, 160, and 170 related to the surface mount technology are each connected to the control device 180 via a network. The number of user terminals 190 and devices 120, 130, 140, 150, 160, and 170 related to the surface mount technology may vary, depending on the number of lines in a substrate processing process or the number of users. Furthermore, FIG. 1 illustrates only an exemplary embodiment for accomplishing the purposes of the present disclosure, and as needed, some elements may be merged into other elements, some elements may be deleted, or some elements may be added.

Referring to FIG. 1, a substrate processing process may be performed on a substrate 110 by the devices 120, 130, 140, 150, 160, and 170 related to the surface mount technology. Here, substrate processing processes identical to the substrate processing process performed on the substrate 110 may be performed in turn on substrates of the same type as the substrate 110. When the substrate processing process is performed on the substrate 110, at least some of the devices 120, 130, 140, 150, 160, and 170 related to the surface mount technology may transmit various types of information about the substrate processing process to the control device 180 or receive various types of information or control signals about the substrate processing process from the control device 180.

The devices related to the surface mount technology may be a solder printing device 120, a first measuring device 130, a component mounting device 140, a second measuring device 150, an oven 160, or a third measuring device 170.

With respect to a solder printing process included in the substrate processing process, the solder printing device 120 or the first measuring device 130 may be involved in the solder printing process. The solder printing device 120 may print solder on the substrate 110. Specifically, the solder printing device 120 may print solder on pads included in the substrate 110 (e.g., a pair of electrodes arranged in positions on the substrate where parts are to be coupled). The solder printing device 120 may be referred to as a screen printer. In addition, the first measuring device 130 may measure the printed state of the solder. The printed state of the solder may include, for example, the location, direction, volume, height, or area of the printed solder. Here, the first measuring device 130 may provide feedback to the solder printing device 120 based on the printed state of the solder. Based on the provided feedback, the solder printing device 120 may perform a printing process as a result of reflecting the feedback on the same type of substrate which follows the substrate 110. The first measuring device 130 may be referred to as a solder paste inspection (SPI) device.

With respect to a component mounting process included in the substrate processing process, the component mounting device 140 or the second measuring device 150 may be involved in the component mounting process.

With respect to the component mounting process included in the substrate processing process, the component mounting device 140 may mount a component on the substrate 110 on which solder is printed. In addition, the component mounting device 140 may calculate the number of components picked up (or attempted to be picked up) and transmit the calculated value to the second measuring device 150 or the control device 180. The component mounting device 140 may be referred to as a mounter.

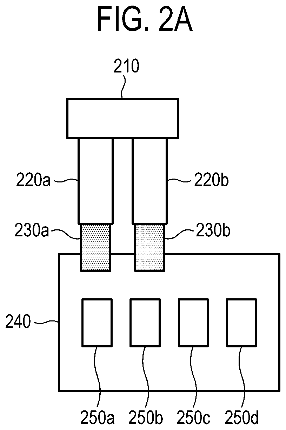

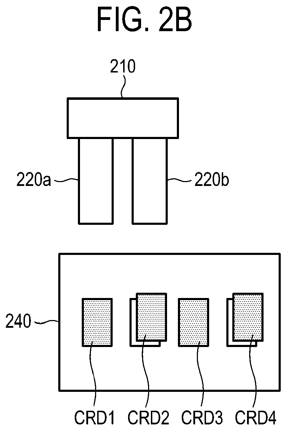

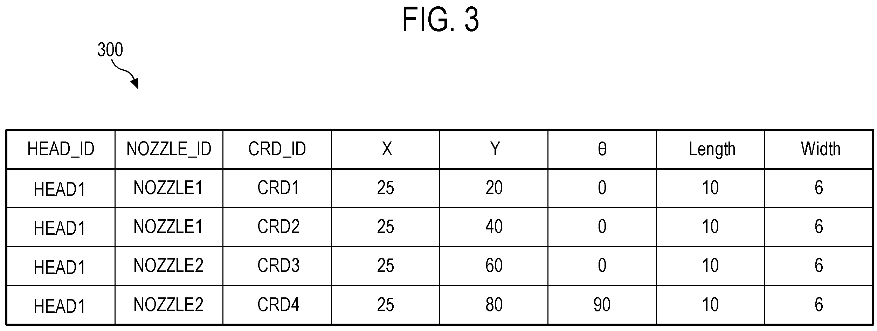

Referring to FIGS. 2A, 2B and 3 for a more detailed description of a mounting operation performed by the component mounting device 140, the component mounting device 140 may include a header 210 or nozzles 220a and 220b as parts that constitute the device. In the mounting operation, the component mounting device 140 may mount components 230a and 230b on a substrate 240 by temporarily coupling the components 230a and 230b to the nozzles 220a and 220b connected to the header 210, moving the header 210 to position the components 230a and 230b in some of regions 250a, 250b, 250c, and 250d on the substrate 240 according to mounting criteria, and releasing the temporary coupling of the components 230a and 230b to the nozzles 220a and 220b. The mounting criteria on which the mounting of the components 230a and 230b is based may be predetermined in the same manner as a reference table 300 illustrated in FIG. 3, for example, by two-dimensional coordinate values (X, Y) and a rotation angular value (θ). As a result of the mounting, multiple components CRD1, CRD2, CRD3, and CRD4 may each be mounted on the substrate 240 so as to correspond to the regions 250a, 250b, 250c, and 250d according to the mounting criteria. Here, some components CRD1 and CRD3 may be mounted so as not to have offsets (e.g., a position offset or an angle offset) from the regions 250a and 250c according to the mounting criteria, and the other components CRD2 and CRD4 may be mounted so as to have offsets from the regions 250b and 250d according to the mounting criteria. These offsets may be due to various noises accompanying the mounting operation of the component mounting device 140, or may be due to malfunctions (e.g., abnormal states) of parts constituting the component mounting device 140. Specific methods, such as determining the type of an offset caused by malfunctions of the parts constituting the component mounting device 140 and the causes thereof, will be described through the following description in the specification.

With respect to the component mounting process included in the substrate processing process, the second measuring device 150 may measure the mounted state of a component. As used herein, the mounted state may refer to the state in which the component mounting device 140 has mounted the component. The second measuring device 150 may generate mounting result information by measuring the mounted state. The mounting result information may include, for example, primary information such as the mounting position of the component (e.g., two-dimensional and three-dimensional coordinate values obtained by measuring a position in which the component is mounted) or the mounting angle of the component (e.g., angular values obtained by measuring angles at which the component is mounted). The mounted state may also include secondary information obtained by processing primary information, such as position offsets, angle offsets, an average of the position offsets, a variance of the position offsets, an average of the angle offsets, a variance of the angle offset, or the number of missing components. The second measuring device 150 may transmit the aforementioned mounting result information to the control device 180. Furthermore, the second measuring device 150 may provide feedback to the component mounting device 140 based on the mounted state of the component. Based on the provided feedback, the component mounting device 140 may perform a component mounting process as a result of reflecting the feedback on the same type of substrate that follows the substrate 110. The second measuring device 150 may be referred to as a pre-automated optical inspection (AOI) device.

With respect to a reflow process included in the substrate processing process, the oven 160 or the third measuring device 170 may be involved in the reflow process. The oven 160 may melt and then solidify the solder printed on the substrate 110 to bond a component to the substrate 110. Furthermore, the third measuring device 170 may measure the bonded state of the component (e.g., the bonded position and the bonded angle of the component) after the reflow process. Here, the third measuring device 170 may provide feedback to the oven 160 based on the bonded state of the components. Based on the provided feedback, the oven 160 may perform a reflow process as a result of reflecting the feedback on the same type of substrate that follows the substrate 110. The third measuring device 170 may be referred to as a postautomated optical inspection (AOI) device.

The devices 120, 130, 140, 150, 160, and 170 related to the surface mount technology may perform all known operations for performing the surface mount technology, in addition to the above-described operation.

Hereinafter, to clarify the main points of the present disclosure, the component mounting process, among the substrate processing processes described so far, and operations of the devices involved in the process will be described in detail. Hereinafter, the second measuring device 150, which measures the mounted state of a component, may be briefly referred to as the measuring device 150.

The control device 180 may obtain mounting result information (e.g., first mounting result information) from the measuring device 150. The mounting result information may be information obtained by measuring the mounted state of a component (e.g., a target component) mounted on the substrate 110 (e.g., a target substrate) by the component mounting device 140. For example, the mounting result information may include at least one selected from a measurement value of a component mounting position, represented by two- and/or three-dimensional coordinates, and a measurement value of a component mounting angle. In another example, the mounting result information may include the number of missing components. In an embodiment, the number of missing components may be generated in association with the number of components picked up (or attempted to be picked up) by the component mounting device 140. For example, the number of missing components may be the difference between the number of components picked up and the number of components actually mounted. In another example, the mounting result information may include a value of at least one among a position offset, an angle offset, an average of position offsets, a variance of position offsets, an average of angle offsets, and a variance of angle offsets. In another example, the mounting result information may include an image obtained by photographing the mounted state of a component on the substrate 110.

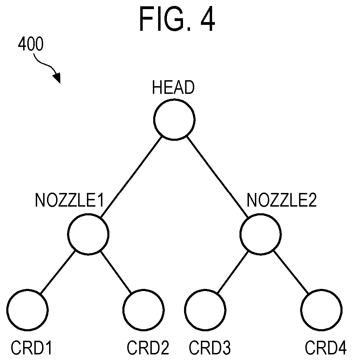

The control device 180 may obtain a hierarchical relationship of plurality of parts (e.g., a head, nozzles, etc.) constituting the component mounting device 140. As illustrated in FIG. 4, a hierarchy relationship 400 may be determined by the physical connection relationship between the plurality of parts constituting the component mounting device 140. Referring to the hierarchical relationship 400 in FIG. 4, for example, "HEAD" may have a physical connection relationship with "NOZZLE 1" and "NOZZLE 2". Furthermore, according to the hierarchical relationship 400, "NOZZLE 1" may have a physical connection relationship with each of "CRD1" and "CRD2" such that "CRD1" and "CRD2" are mounted by "NOZZLE 1", and "NOZZLE 2" may have a physical connection relationship with each of "CRD3" and "CRD4" such that "CRD3" and "CRD4" are mounted by "NOZZLE 2".

Based on the mounting result information and the hierarchical relationship, the control device 180 may determine the state of at least one of the plurality of parts constituting the component mounting device 140. If a first part among the plurality of parts does not satisfy predetermined criteria, the first part may be determined to be in an abnormal state. Also, if a second part among the plurality of parts satisfies predetermined criteria, the second part may be determined to be in a normal state. That is, the abnormal state of a part may indicate a determination that the part does not satisfy predetermined criteria regarding the part. Here, the predetermined criteria may be criteria determined based on mounting result information and/or a hierarchical relationship.

When it is determined that the at least one of the plurality of parts constituting the component mounting device 140 is in an abnormal state, the control device 180 may control the measuring device 150 to stop providing feedback to the component mounting device 140. The feedback may be a means for adjusting offsets caused by various noises that accompany the mounting operation of the component mounting device 140. When an offset is caused by an abnormal state of a part of the component mounting device 140, the degree of feedback may increase excessively, and thus the mounting operation of the component mounting device 140 may become inaccurate, or the mounting operation of the component mounting device 140 may become inaccurate after the repair of the part. Accordingly, the control device 180 may control the measuring device 150 to stop the feedback that the measuring device 150 provides to the component mounting device 140.

The control device 180 may control the measuring device 150 to resume feedback in response to a signal indicating that the part determined to be in the abnormal state is repaired. The part determined to be in the abnormal state is in a normal state by the repair of the part, and thus in order to adjust offsets caused by various noises accompanying the mounting operation of the component mounting device 140, the control device 180 may control the measuring device 150 to resume providing feedback to the component mounting device 140. In addition to the above-described operation, the control device 180 may perform various operations of managing and controlling the component mounting process.

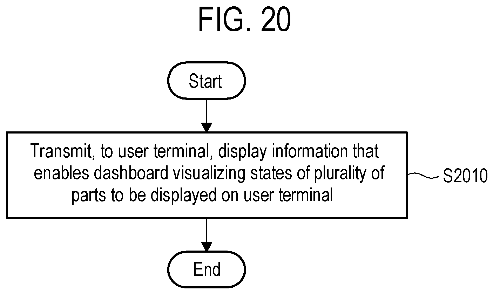

In addition, the control device 180 may perform operations associated with the user terminal 190 to visualize information (e.g., a dashboard) regarding the component mounting process to a user. Specifically, the control device 180 may transmit, to the user terminal 190, display information that enables the dashboard, which visualizes the states of the plurality of parts constituting the component mounting device 140, to be displayed on the user terminal 190. That is, the control device 180 may transmit display information to the user terminal 190 so that the user can identify various types of information related to the surface mount technology via the user terminal 190. In an embodiment, the display information may include information about a part determined to be in an abnormal state, among the plurality of parts constituting the component mounting device 140. Operations related to the dashboard or the like visualized on the user terminal 190 will be described later with reference to FIGS. 20 to 22.

The control device 180 described above may be implemented as at least one computing device. For example, all functions of the control device 180 may be implemented in a single computing device. In another example, a first function of the control device 180 may be implemented in a first computing device, and a second function may be implemented in a second computing device. Such a computing device may be, for example, but not limited to, a desktop computer, a laptop computer, an application server, a proxy server, or a cloud server, and any type of device with a computing function may be a computing device.

The user terminal 190 described so far is a terminal used by a user (e.g., a person managing and controlling the processing of the surface mount technology), and may display, on a display, various types of information obtained from the control device 180. Communication between the control device 180 and the user terminal 190 may be performed via a user interface. The aforementioned user terminal 190 may be, for example, but not limited to, a desktop computer, a laptop computer, a tablet computer, a wearable device, or a smart phone, and any type of device with a computing function may be the user terminal 190. In addition, the user terminal 190 may have a web browser or an application installed to receive the above-described user interface from the control device 180.

Each of the above-described devices 120, 130, 140, 150, 160, 170, 180, and 190 illustrated in FIG. 1 may communicate over a network. The network may be implemented as any kind of wired or wireless network, such as a local area network (LAN), a wide area network (WAN), a mobile radio communication network (MRCN), or wireless broadband (WiBro).

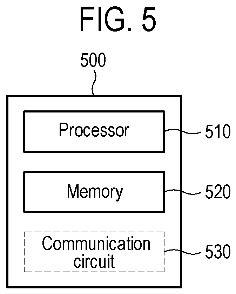

FIG. 5 illustrates a computing device 500 capable of implementing all or some of the devices 120, 130, 140, 150, 160, 170, 180, and 190 according to an embodiment of the present disclosure. That is, all or some of the solder printing device 120, the first measuring device 130, the component mounting device 140, the second measuring device 150, the oven 160, the third measuring device 170, the control device 180, or the user terminal 190 illustrated in FIG. 1 may be implemented by the computing device 500 illustrated in FIG. 5. For reference, in the present disclosure, the computing device 500 may be referred to interchangeably with a device or an electronic device.

Referring to FIG. 5, the computing device 500 may include at least one processor 510, at least one memory 520, or a communication circuit 530. In an embodiment, some elements (e.g., the communication circuit) may be removed from computing device 500 and/or another element (e.g., a display or an input device) may be added to the computing device 500. Additionally or alternatively, some elements may be integrated, or may be implemented as a single entity or multiple entities. In the present disclosure, the at least one processor 510 may be referred to as the processor 510. The term "processor 510" may refer to a set of one or more processors, unless the context clearly indicates otherwise. In addition, in the present disclosure, the at least one memory 520 may be referred to as the memory 520. The term "memory 520" may refer to a set of one or more memories, unless the context clearly indicates otherwise.

The processor 510 may perform operations or information processing related to the control or communication of the elements of the computing device 500. Specifically, the processor 510 may execute software (or a computer program) received from another element to control at least one element of the computing device 500 connected to processor 510. In one example, the processor 510 may load commands (e.g., instructions, codes, or code segments) or information into the memory 520, may process the commands or information stored in the memory 520, and may store information resulting from the processing in the memory 520. In addition, the processor 510 may be operatively connected to the elements of the computing device 500 to perform various operations, such as computing, processing, generation, or manipulation, related to the present disclosure.

The memory 520 may store various types of information. The information stored in the memory 520 may be acquired, processed, or used by at least one element of the computing device 500, and may include software. The software may include one or more commands which, when loaded into the memory 520, cause the processor 510 to perform operations according to various embodiments of the present disclosure. That is, the processor 510 may perform operations according to various embodiments of the present disclosure by executing the one or more commands described above. The memory 520 may include, for example, volatile or non-volatile memory. In an embodiment, the program is software stored in the memory 520 and may include an operating system for controlling resources of the computing device 500, an application, or middleware that provides various functions to an application to allow the application to utilize the resources of the computing device 500.

The communication circuit 530 may establish a wired or wireless communication channel with another device, and may transmit and receive various types of information to and from the other device. In an embodiment, in order to communication with another device in a wired manner, the communication circuit 530 may include at least one port so as to be connected to the other device by a wired cable. In this case, the communication circuit 530 may use the at least one port to communicate with the other device which is connected by the wired cable. In an embodiment, the communication circuit 530 may include a cellular communication module and be configured to be connected to a cellular network (e.g., 3G, LTE, 5G, WiBro, or WiMAX). In an embodiment, the communication circuit 530 may include a short-range communication module to transmit and receive information to and from other devices by using short-range communication (e.g., Wi-Fi, Bluetooth, Bluetooth Low Energy (BLE), or UWB). In an embodiment, the communication circuit 530 may include a contactless communication module for contactless communication. The contactless communication may include at least one contactless proximity communication technology, such as near-field communication (NFC), radio frequency identification (RFID) communication, or magnetic secure transmission (MST) communication. In addition to the above-described various examples, the computing device 500 may be implemented in various known ways to communicate with other devices, and the scope of the present disclosure is not limited by the foregoing examples.

In an embodiment, the communication circuit 530 may be omitted from the computing device 500.

In an embodiment, the computing device 500 may include a display. The display may display various screens (e.g., one or more pages) under control of the processor 510. For example, a web browser or a dedicated application may be installed in the computing device 500 in order to display a screen, on which various interfaces are applied, on the display. Furthermore, the display may be configured to be interactive with a user and may receive a user input from the user. The display may be implemented in the form of a touch sensor panel (TSP) capable of recognizing the touch or proximity of various external objects (e.g., the user's finger or stylus).

In an embodiment, the computing device 500 may include an input device (e.g., a mouse or a keyboard). The input device may receive, from outside of the computing device 500 (e.g., from a user), information to be used by the elements of the computing device 500.

The processor 510, the memory 520, and/or the communication circuitry 530 may be connected to each other via a bus, general purpose input/output (GPIO), serial peripheral interface (SPI), or mobile industry processor interface (MIPI) to send or receive information or signals.

Hereinafter, a method according to various embodiments of the present disclosure will be described in detail. It should be noted that although the drawings below illustrate operations in a specific order, the operations do not necessarily have to be executed in the illustrated specific order or sequential order, nor do all of the illustrated operations have to be executed to achieve a desired result.

Furthermore, the operations of the method to be described with reference to the drawings below may be performed by a computing device. In other words, the operations of the method may be implemented as one or more instructions executed by a processor of the computing device. All operations included in the method may be performed by a single physical computing device. However, for example, a first operation of the method may be performed by a first computing device, and a second operation of the method may be performed by a second computing device. That is, the operations of the method may be separately performed by multiple computing devices.

Hereinafter, the description will continue assuming that the operations of the method described above are performed by the control device 180 illustrated in FIG. 1. Furthermore, for ease of description, the subject of the operations included in the method may be omitted, but unless indicated otherwise in context, it may be interpreted that the operations are performed by the control device 180.

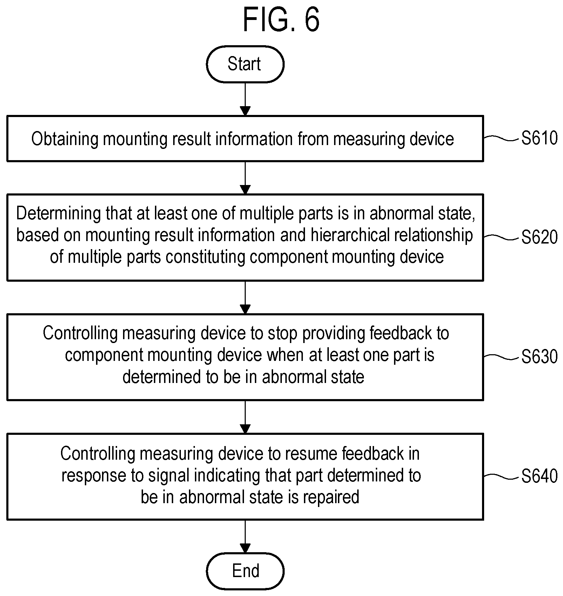

FIG. 6 illustrates a flowchart showing a method according to an embodiment of the present disclosure. The flowchart illustrated in FIG. 6 includes a series of operations of the control device 180 which determines the abnormal state (e.g., malfunction) of parts constituting the component mounting device 140 and controls the measuring device 150 based on the determination.

Mounting result information may be obtained from the measuring device 150 (S610). The mounting result information may be a generic term for information obtained by measuring a state (e.g., a mounted state) in which a component is mounted on a substrate. For example, the mounting result information may include first mounting result information obtained by measuring a state in which a target component is mounted on a target substrate. Here, the target substrate may be a substrate undergoing a substrate processing process, and the target component may be a component mounted on the target substrate. Furthermore, the mounting result information may include second mounting result information obtained by measuring a state in which components of the same type as the target component are mounted on plurality of substrates each having a layout identical to that of the target substrate. The plurality of substrates may be substrates that undergo a substrate processing process subsequent to the target substrate, and a component of the same type as the target component mounted on the target substrate may be mounted on each of the plurality of substrates. Since the target component and the components of the same type as the target component are mounted on different substrates but are mounted by one part (e.g., a target part) of the component mounting device 140, the mounted state of multiple components mounted by the one part may be obtained by the mounting result information acquisition operation S610. In addition, the mounting result information may include third mounting result information obtained by measuring a state in which a first component and a second component are mounted on the target substrate. Here, the first component and the second component may be components mounted by one target part (e.g., a header, a nozzle, etc.) of the component mounting device 140. That is, the first component and the second component are different components mounted on the target substrate, but are mounted by one part (e.g., the target part) of the component mounting device 140, so that the mounted state of multiple components mounted by the one part may be obtained by the mounting result information acquisition operation S610.

In an embodiment, the mounting result information may include at least one of two- and three-dimensional coordinate values, obtained by measuring a position (e.g., a mounting position) where a component is mounted on the substrate, and an angular value, obtained by measuring an angle (e.g. a mounting angle) at which the component is mounted. That is, at least one of the two- and three-dimensional coordinate values and the angular value may be obtained from the measuring device 150. The coordinate values may be determined from the relationship between a first point uniquely determined with respect to the substrate and a second point occupied by a component mounted on the substrate (e.g., the center of gravity of the component). The angular value may also be determined from the relationship between a first line uniquely determined with respect to the substrate and a second line occupied by the component mounted on the substrate.

In another embodiment, the mounting result information may include an image obtained by photographing a state in which a component is mounted on the substrate. That is, the image may be obtained from the measuring device 150.

Based on the mounting result information and the hierarchical relationship of the plurality of parts constituting the component mounting device 140, it may be determined that at least one of the plurality of parts is in an abnormal state (S620).

The operation S620 may include an operation of determining an offset for at least one component based on the mounting result information. The offset determination operation may be an operation of determining the difference between a mounted state of the component and predetermined mounting criteria. Specifically, the offset determination operation may include determining a position offset between a mounting position of a component and a mounting position indicated by the mounting criteria with respect to the component. Furthermore, the offset determination operation may include an operation of determining an angle offset between a mounting angle of a component and a mounting angle dictated by the mounting criteria with respect to the component. Thereby, the offset may include at least one of the position offset and the angle offset. For example, when the mounting position of "CRD1" is {30, 20} and when the mounting position indicated by mounting criteria for "CRD1" is {25, 20} as illustrated in FIG. 3, the position offset of "CRD1" may be determined to be {5, 0}. Also, when the mounting angle of "CRD1" is {10} and when the mounting angle indicated by the mounting criteria for "CRD1" is {0} as illustrated in FIG. 3, the angle offset of "CRD1" may be determined to be {10}.

The offset determination operation, for example, may be performed for the target component mounted on the target substrate based on the first mounting result information, may be performed for each of the components of the same types mounted on the plurality of substrates based on the second mounting result information, or may be performed for each of the first component and the second component based on the third mounting result information.

According to the offset determination operation, the difference between the mounted state of the component and the predetermined mounting criteria may be simply determined as a numerical value. The numerical value may be used to determine an abnormal state according to the operation S620.

When the mounting result information includes an offset (e.g., a position offset or an angle offset) or a statistical value of the offset, the above-described offset determination operation may be omitted. In this case, for example, the measuring device 150 may perform the above-described offset determination operation.

Furthermore, the operation S620 may include an operation of determining a statistical value (e.g., an average or a variance) of offsets of at least one component mounted by one part of the component mounting device 140. The operation of determining the statistical value may include, for example, determining, based on the first mounting result information to the third mounting result information, a statistical value of offsets of one or more components (e.g., the target component, the components of the same type, the first component, or the second component) mounted by one part of the component mounting device 140. In a specific example, the operation of determining the statistical value may include determining a first statistical value of offsets of one or more components mounted by a first head of the component mounting device 140, may include determining a second statistical value of offsets of one or more components mounted by a first nozzle physically connected to the first head, or may include determining a third statistical value of offsets of one or more components mounted by a second nozzle physically connected to the first head.

According to the operation of determining the statistical value, a statistical value regarding offsets of one or more components affecting each individual part of the component mounting device 140 may be determined. When a trend is found in the statistical value regarding the offsets, it may be determined that at least one of the plurality of parts constituting the component mounting device 140 is in an abnormal state. For example, when the average of position offsets deviates from the mounting position according to the mounting criteria, when the variance of the position offsets is outside the range of the mounting position according to the mounting criteria, when the average of the angle offsets deviates from the mounting angle according to the mounting criteria, when the variance of the angle offsets is outside the range of the mounting angle according to the mounting criteria, or when the variance of the angle offsets is missing, at least one of the plurality of parts constituting the component mounting device 140 may be determined to be in an abnormal state.

When the mounting result information includes a statistical value of an offset, the above-described operation of determining the statistical value may be omitted. In this case, for example, the measuring device 150 may perform the above-described operation of determining the statistical value.

Furthermore, the operation S620 may include an operation of determining, based on a hierarchical relationship of the component mounting device 140, that at least one of the parts of the component mounting device 140 is in an abnormal state. According to the operation of determining an abnormal state based on the hierarchical relationship, a part of the component mounting device 140 that causes a trend in the statistical value may be more clearly identified.

In a specific example, it is assumed that "CRD1" and "CRD2" are mounted by the first nozzle of the component mounting device 140, "CRD3" and "CRD4" are mounted by the second nozzle of the component mounting device 140, and the first nozzle and the second nozzle are physically connected to the first head of the component mounting device 140. When a certain trend is found in a statistical value of offsets for "CRD1" to "CRD4", a part causing the trend in the statistical value may be identified as the first head. Furthermore, when a certain trend is not found in the statistical value of the offsets for "CRD1" to "CRD4", but when a certain trend is found in a statistical value of offsets for "CRD1" and "CRD2", a part causing the trend in the statistical value may be identified as the first nozzle. Also, when a certain trend is not found in the statistical value of the offsets for "CRD1" to "CRD4", but when a certain trend is found in a statistical value of offset for "CRD3" and "CRD4", a part causing the trend in the statistical value may be identified as the second nozzle.

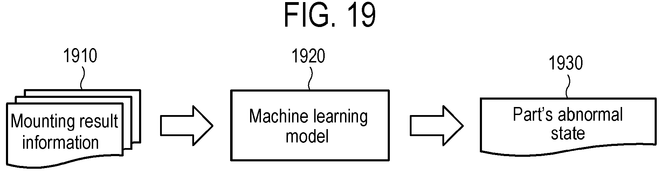

In an embodiment, the operation S620 may include an operation of determining that at least one of the plurality of parts is in an abnormal state, based on a machine learning model trained on the correlation between the mounting result information and the abnormal state of parts. Here, the machine learning model may be stored in a memory of the control device 180 after the training is complete. The machine learning model will be described in detail later with reference to FIG. 19.

When it is determined that the at least one of the plurality of parts is in the abnormal state, the measuring device 150 may be controlled to stop providing feedback to the component mounting device 140 (S630).

Feedback may be a means for adjusting offsets resulting from various noises that accompany the mounting operation of the component mounting device 140. The feedback may be applied to subsequent substrates based on an offset for the target substrate undergoing the substrate handling process, so that the offset is adjusted for the subsequent substrates. However, when an offset is caused by the abnormal state of a part of the component mounting device 140, the degree of feedback may increase excessively, and thus the mounting operation of the component mounting device 140 may become inaccurate, or the mounting operation of the component mounting device 140 may become inaccurate after the repair of the part. Accordingly, according to the operation S630, the measuring device 150 may be controlled to stop providing feedback to the component mounting device 140, based on the result of the abnormal state determination operation S620.

In an embodiment, the stop of feedback may be applied to some of the multiple components included in the substrate.

Before the determination of the abnormal state according to the abnormality determination operation S620, feedback may be continuously applied to plurality of substrates on which substrate processing processes are performed. Since the abnormal state determination operation S620 may require plurality of substrates, feedback corresponding to the offset caused by the abnormal state of a part of the component mounting device 140 may be cumulatively applied to the component mounting device 140. Therefore, at the time of determination of the abnormal state according to the abnormal state determination operation S620, at least some of the feedback cumulatively applied to the component mounting device 140 may be initialized.

In response to a signal indicating that the part determined to be in the abnormal state is repaired, the measuring device 150 may be controlled to resume feedback (S640).

The signal indicating that the part determined to be in the abnormal state is repaired may be obtained from an external device (e.g., the user terminal 190). Repairing a part may be understood as a broad concept that includes replacing a part.

When the part is repaired, an offset due to the abnormal state of the part of the component mounting device 140 is no longer occurring. Therefore, according to the operation S640, 140 in order adjust the offset caused by various noises accompanying the mounting operation of the component mounting device 140, the measuring device 150 may be controlled to resume providing feedback to the component mounting device.

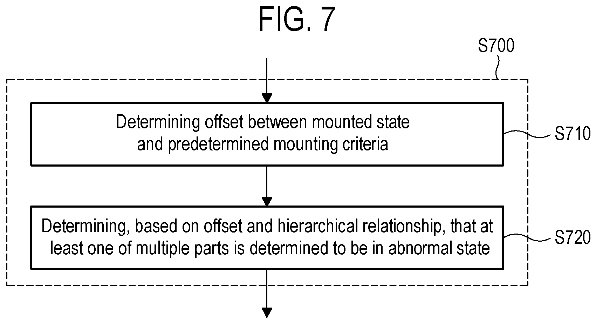

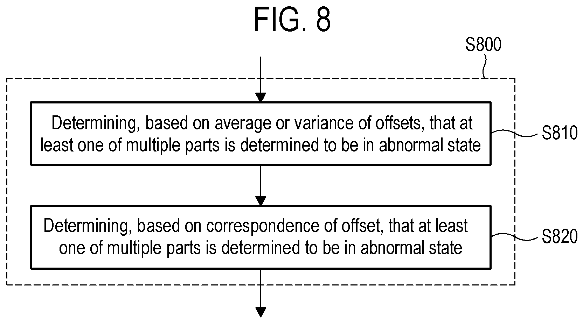

FIGS. 7 and 8 illustrate flowcharts showing operations of determining an abnormal state according to an embodiment of the present disclosure. Step S700 in FIG. 7 and step S800 in FIG. 8 each indicate the abnormal state determination operation S620.

The control device 180 may determine an offset between a mounted state and predetermined mounting criteria (S710), and may determine that at least one of plurality of parts is in an abnormal state (S720) based on the offset and the hierarchical relationship. Step S710 may correspond to the offset determination operation described with reference to step S620. Furthermore, step S720 may at least partially correspond to the statistical value determination operation described with reference to step S620 and/or the operation of determining an abnormal state based on the hierarchical relationship.

Referring to FIG. 8, based on an average or a variance of offsets, it may be determined that at least one of plurality of parts is in an abnormal state (S810), and based on a correspondence of the offset, it may be determined that the at least one of the plurality of parts is in the abnormal state (S820).

Step S810 may at least partially correspond to the operation of determining the statistical value, described with reference to step S620, and/or the operation of determining the abnormal state based on the hierarchical relationship. Step S810 may include, for example, an operation of determining that the at least one of the plurality of parts is in the abnormal state based on an average or a variance of an offset of the target component mounted on the target substrate and an offset of a component which is of the same type as the target component and is mounted on each of plurality of substrates subsequent to the target substrate. Furthermore, step S820 may at least partially correspond to the operation of determining the abnormal state based on the hierarchical relationship, described with reference to step S620. Step S820 may include, for example, an operation of determining that the target part involved in mounting the first component and the second component on the target substrate is in an abnormal state, based on a determination that offsets of the first component and the second component mounted on the target substrate correspond to each other (e.g., have the same trend).

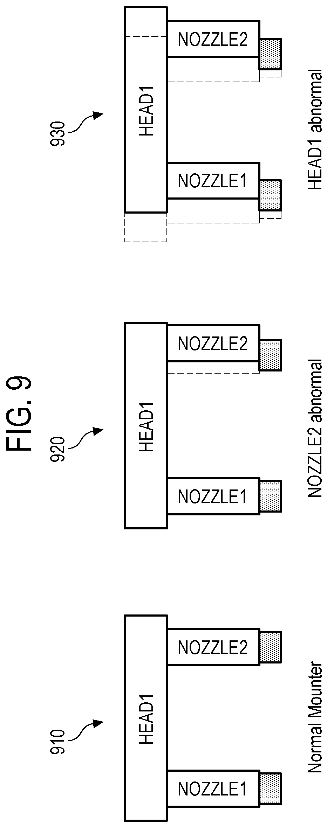

FIGS. 9 to 18 illustrate types of abnormal states of the component mounting device 140 and mounting results based on the types of abnormal states, which may be referred to in various embodiments of the present disclosure.

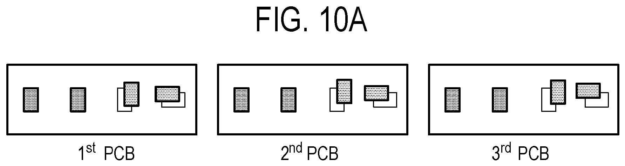

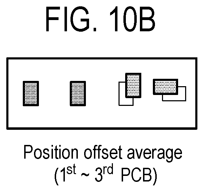

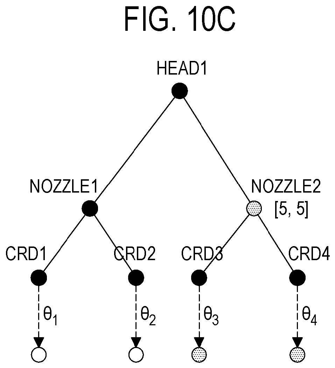

A type of abnormal state of the component mounting device 140, which will be described with reference to FIGS. 9 and 10, is a type in which the positions of some parts of the component mounting device 140 are offset. Referring to FIG. 9, for example, when compared with a normal state 910, an abnormal state 920 involves a position offset of "NOZZLE 2", and an abnormal state 930 involves a position offset of "HEAD 1".

When the average of position offsets of components mounted by "NOZZLE 1" and the average of position offsets of components mounted by "NOZZLE 2" are both in a mounting position based on the mounting criteria, all parts of the component mounting device 140 may be determined to be in an abnormal state. In addition, as illustrated in FIGS. 10A, 10B and 10C, when the average of the position offsets of the components mounted by "NOZZLE 1" is in the mounting position based on to the mounting criteria, but when the average of the position offsets of the components mounted by "NOZZLE 2" deviates from the mounting position based on the mounting criteria, "NOZZLE 2" of the component mounting device 140 may be determined to be in an abnormal state. In addition, when the average of the position offsets of the components mounted by "NOZZLE 1" and the average of the position offsets of the components mounted by "NOZZLE 2" are both offset from the mounting position based on the mounting criteria by the same degree, "HEAD 1" of the component mounting device 140 may be determined to be in an abnormal state.

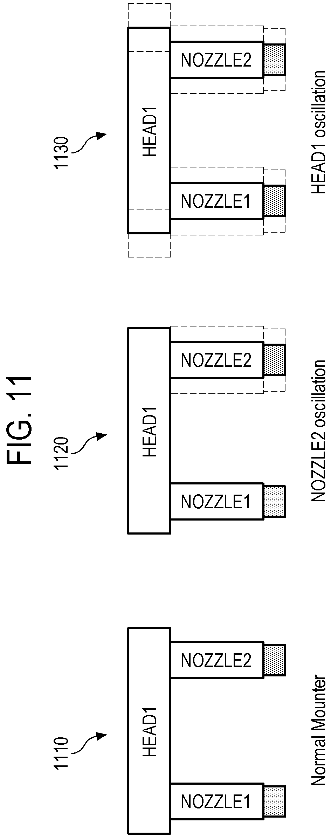

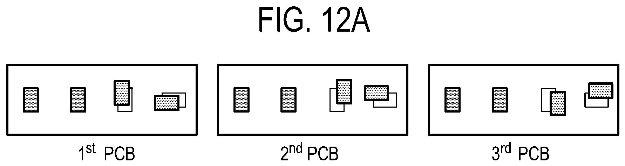

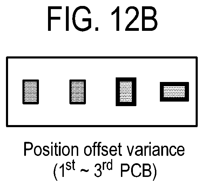

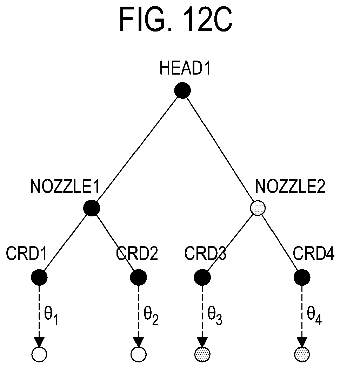

A type of abnormal state of the component mounting device 140, which will be described with reference to FIGS. 11, 12A, 12B and 12C, is a type in which the positions of some parts of the component mounting device 140 oscillate. Referring to FIG. 11, for example, when compared with a normal state 1110, an abnormal state 1120 causes the position of "NOZZLE 2" to oscillate, and an abnormal state 1130 causes the position of "HEAD 1" to oscillate.

When the variance of position offsets of components mounted by "NOZZLE 1" and the variance of position offsets of components mounted by "NOZZLE 2" are both within the range of the mounting position based on the mounting criteria, all parts of the component mounting device 140 may be determined to be in a normal state. In addition, as illustrated in FIGS. 12A, 12B and 12C, when the variance of the position offsets of the components mounted by "NOZZLE 1" is within the range of the mounting position based on the mounting criteria, but when the variance of the position offsets of the components mounted by "NOZZLE 2" is outside the range of the mounting position based on the mounting criteria, "NOZZLE 2" of the component mounting device 140 may be determined to be in an abnormal state. In addition, when the variance of the position offsets of the components mounted by "NOZZLE 1" and the variance of the position offsets of the components mounted by "NOZZLE 2" both deviate from the mounting position based on the mounting criteria by the same degree, "HEAD 1" of the component mounting device 140 may be determined to be in an abnormal state.

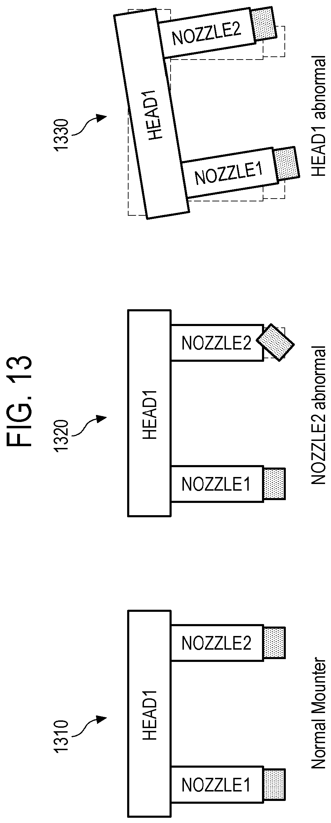

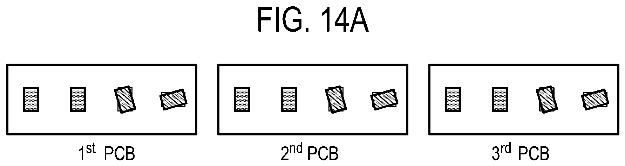

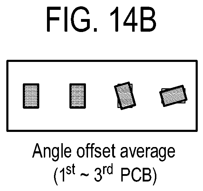

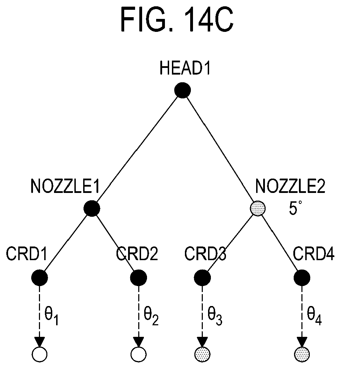

A type of abnormal state of the component mounting device 140, which will be described with reference to FIGS. 13, 14A, 14B and 14C, is a type in which the angles of some parts of the component mounting device 140 are offset. Referring to FIG. 13, for example, when compared with a normal state normal 1310, an abnormal state 1320 involves angle offset of "NOZZLE 2", and an abnormal state 1330 involves an angle offset of "HEAD 1".

When the average of angle offsets of components mounted by "NOZZLE 1" and the average of angle offsets of components mounted by "NOZZLE 2" are both in a mounting angle based on mounting criteria, all parts of the component mounting device 140 may be determined to be in a normal state. In addition, as illustrated in FIGS. 14A, 14B and 14C, when the average of the angle offsets of the components mounted by "NOZZLE 1" is in the mounting angle based on the mounting criteria, but when the average of the angle offsets of the components mounted by "NOZZLE 2" deviates from the mounting angle based the mounting criteria, "NOZZLE 2" of the component mounting device 140 may be determined to be in an abnormal state. In addition, if the average of angle offsets of components mounted by "NOZZLE 1" and the average of angle offsets of components mounted by "NOZZLE 2" both deviate from the mounting angle based on the mounting criteria by the same degree, "HEAD 1" of the component mounting device 140 may be determined to be in an abnormal state.

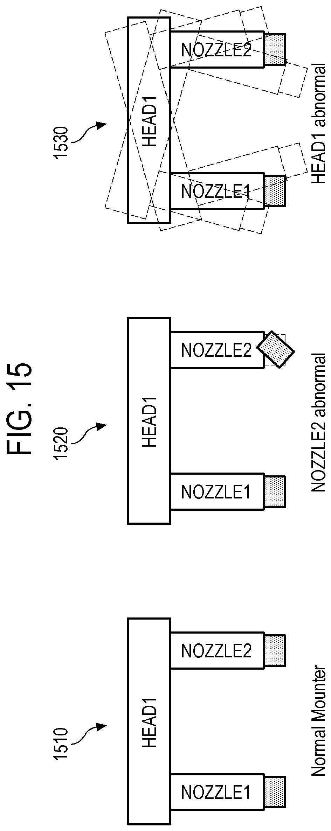

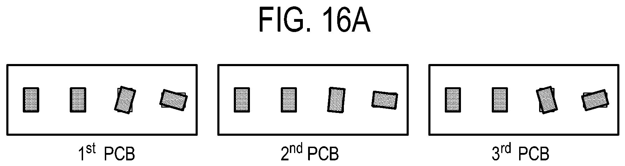

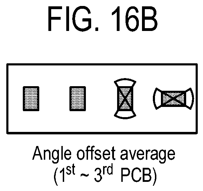

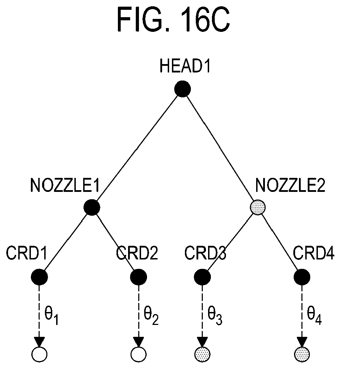

A type of abnormal state of the component mounting device 140, which will be described with reference to FIGS. 15, 16A, 16B and 16C, is a type in which the angles of some parts of the component mounting device 140 oscillate. Referring to FIG. 15, for example, when compared with a normal state 1510, an abnormal state 1520 causes the angle of "NOZZLE 2" to oscillate, and an abnormal state 1530 causes the angle of "HEAD 1" to oscillate.

When the variance of angle offsets of components mounted by "NOZZLE 1" and the variance of angle offsets of components mounted by "NOZZLE 2" are both within the range of a mounting angle based on mounting criteria, all parts of the component mounting device 140 may be determined to be in a normal state. In addition, as illustrated in FIGS. 16A, 16B and 16C, when the variance of the angle offsets of the components mounted by "NOZZLE 1" is within the range of the mounting angle based on the mounting criteria, but when the variance of the angle offsets of the components mounted by "NOZZLE 2" is outside the range of the mounting angle based on the mounting criteria, "NOZZLE 2" of the component mounting device 140 may be determined to be in an abnormal state. In addition, when the variance of the angle offsets of the components mounted by "NOZZLE 1" and the variance of the angle offsets of the components mounted by "NOZZLE 2" both deviate from the range of the mounting angle based on the mounting criteria by the same degree, "HEAD 1" of the component mounting device 140 may be determined to be in an abnormal state.

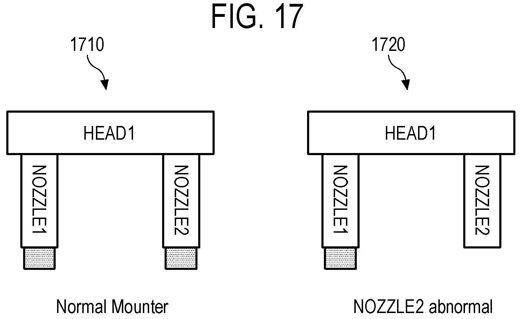

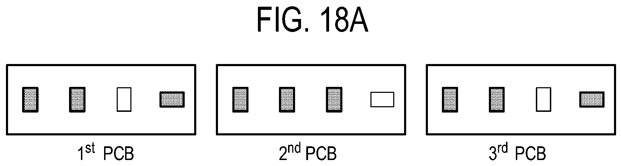

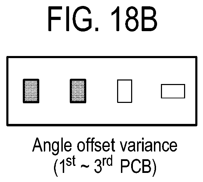

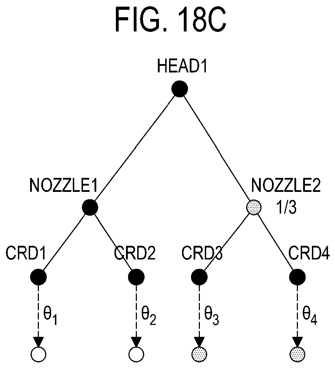

A type of abnormal state of the component mounting device 140, which will be described with reference to FIGS. 17 and 18A, 18B and 18C, is a type in which some parts of the component mounting device 140 fail to pick up a component. For example, it may be assumed that a type of abnormal state where a nozzle of the component mounting device 140 fails to pick up a component. Referring to FIG. 17, for example, in an abnormal state 1720, as compared to a normal state 1710, "NOZZLE 2" fails to pick up a component.

When the variance of angle offsets of components mounted "NOZZLE 1" and the variance of angle offsets of components mounted by "NOZZLE 2" are both within the range of a mounting angle based on mounting criteria, all parts of the component mounting device 140 may be determined to be in a normal state. In addition, as illustrated in FIGS. 18A, 18B and 18C, when the variance of the angle offsets of the components mounted "NOZZLE 1" is included in the range of the mounting angle based on the mounting criteria, but when the variance of the angle offsets of the components mounted by "NOZZLE 2" is missing, "NOZZLE 2" of the component mounting device 140 may be determined to be in an abnormal state. Further, when both the variance of the angle offsets of the components mounted "NOZZLE 1" and the variance of the angle offsets of the components mounted by "NOZZLE 2" are missing, both "NOZZLE 1" and "NOZZLE 2" of the component mounting device 140 may be determined to be in an abnormal state.

The type of abnormal state of the component mounting device 180 illustrated in FIGS. 17 and 18 may be determined by the number of missing components included in mounting result information. For example, when there is no missing component in the components mounted by "NOZZLE 1", but when there is the number of missing components in the components mounted by "NOZZLE 2", "NOZZLE 2" of the component mounting device 140 may be determined to be in an abnormal state.

FIG. 19 illustrates a machine learning model 1920 which may be referred to in various embodiments of the present disclosure. The machine learning model 1920 may be trained in the control device 180 in the manner illustrated in FIG. 19 and then stored in the memory of the control device 180. Additionally, the machine learning model 1920 may be trained outside the control device 180 in the manner illustrated in FIG. 19, and then stored in the memory of the control device 180. That is, the position of the training of the machine learning model 1920 is not a factor limiting the scope of the present disclosure.

The machine learning model 1920 may use mounting result information 1910 and a part's abnormal state 1930 as one training data pair for training. By obtaining multiple training data pairs and using the training data pairs to train the machine learning model 1920, the derivation of correlation between the mounting result information 1910 and the part's abnormal state 1930 may be refined. For the training of the machine learning model 1920, reference may be made to techniques regarding supervised learning wherein an input (e.g., the mounting result information 1910) and a corresponding output (e.g., the part's abnormal state 1930) are included in the training data.

The machine learning model 1920 may be constructed to dynamically perform operation of the control device 180. Furthermore, the machine learning model 1920 may be constructed to determine the type of abnormal state of a part.

As described above, the control device 180 may determine an abnormal state of a part constituting the component mounting device 140 based on a statistical trend in mounting result information obtained by measuring the mounted state of a component and the hierarchical relationship of the component mounting device 140. The abnormal state of the part may cause a mounting error of the component mounting device 140 or an excess of feedback applied to the component mounting device 140. Thus, optimal treatment for the part (e.g., the stop of feedback to a component in which the part is involved, or replacement of the part) may be performed based on the determination of the abnormal state of the part.

FIG. 20 illustrates a flowchart showing a method according to an embodiment of the present disclosure. The flowchart illustrated in FIG. 20 includes an operation of displaying, on the user terminal 190, a dashboard visualizing the state of plurality of parts constituting the component mounting device 140.

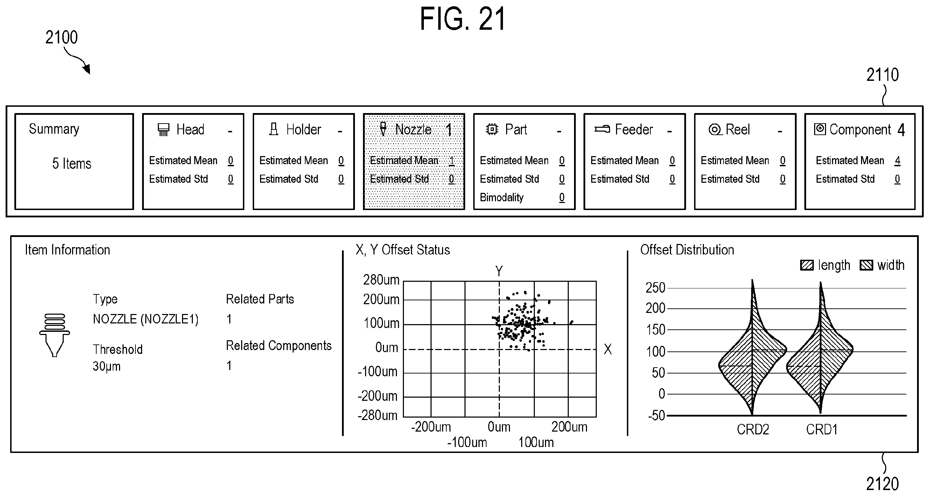

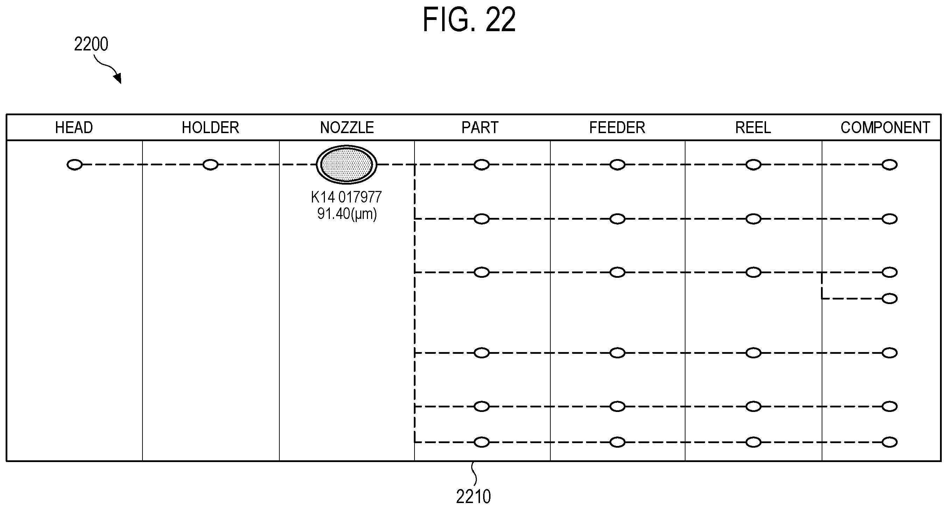

Display information that enables the dashboard visualizing the state of the plurality of parts to be displayed on the user terminal 190 may be transmitted to the user terminal 190 (S2010). The display information may include, for example, information about a part, among the plurality of parts, which is determined to be in an abnormal state. The display information may be, for example, information that highlights an indicator of a part (e.g., "Nozzle") determined to be in an abnormal state, such as a summary area 2110 of a dashboard 2100 illustrated in FIG. 21. In another example, the display information may be information that visualizes details (e.g., offset distribution) of a part (e.g., "NOZZLE 1") determined to be in an abnormal state, such as a part details area 2120 of the dashboard 2100 in FIG. 21. In another example, the display information may be information which, as illustrated in a part hierarchy diagram 2210 of a dashboard 2200 in FIG. 22, includes a hierarchical relationship of the plurality of parts constituting the component mounting device 140 but highlights an indicator of a part (e.g., "K14017977") determined to be in an abnormal state.

According to the embodiment of the present disclosure described with reference to FIGS. 20 to 22, a user may visually identify various types of information regarding a substrate processing process related to surface mount technology. In particular, via the dashboard, the user may visually identify various types of information regarding a part of the component mounting device 140 which is determined to be in an abnormal state that results in a mounting error of the component mounting device 140 or an excessive amount of feedback applied to the component mounting device 140. Thus, the user may immediately identify the part of the component mounting device 140 determined to be in an abnormal state, and may expedite repair of the part.

In the flowcharts of the present disclosure, the operations of the method or algorithm have been described in a sequential order. However, in addition to being performed sequentially, the operation may be performed in any order in which the operations may be randomly combined. The description of the flowcharts in the present disclosure neither excludes making changes or modifications to the method or algorithm, nor implies that a certain operation is necessary or desirable. In an embodiment, at least some operations may be performed in parallel, iteratively, or heuristically. In another embodiment, at least some operations may be omitted, or other operations may be added.

Various embodiments of the present disclosure may be implemented as software recorded in a machine-readable storage medium. The software may be software for implementing the various embodiments of the present disclosure. The software may be inferred from various embodiments of the present disclosure by programmers in a technical field to which the present disclosure belongs. For example, the software may be a computer program including a machine-readable command. A machine may be a device capable of operating based on a command called from the storage medium, and may be referred to interchangeably with, for example, a device or an electronic device. In an embodiment, a processor of the machine may execute a called command to cause elements of the machine to perform a function corresponding to the command. The storage medium may refer to any type of recording medium which stores machine-readable information. The storage medium may include, for example, ROM, RAM, CD-ROM, a magnetic tape, a floppy disk, an optical information storage device, or the like. In an embodiment, the storage medium may be distributed to computer systems connected over a network. The software may be distributed, stored, and executed in the computer systems. In another embodiment, the storage medium may be a non-transitory storage medium. The non-transitory storage medium refers to a tangible medium that exists irrespective of whether information is stored semi-permanently or temporarily, and does not include a transitorily propagated signal.

Although the technical idea of the present disclosure has been described using various embodiments, the technical idea of the present disclosure includes various substitutions, modifications, and changes which may be made within the scope of the present disclosure that can be understood by those skilled in the art to which the present disclosure belongs. Furthermore, it should be understood that such substitutions, modifications, and changes may fall within the accompanying claims.

## Claims

1. A device comprising:
a communication circuit configured to communicate with a measuring device;
at least one processor; and
at least one memory storing commands to be executed by the at least one processor,
wherein the at least one processor is configured to, when the commands are executed:
obtain, from the measuring device, first mounting result information resulting from measuring a state in which a component mounting device has mounted a target component on a target substrate, wherein the component mounting device includes a plurality of parts having a hierarchical relationship;
determine whether at least one part of the plurality of parts is in an abnormal state based on the first mounting result information and the hierarchical relationship; and
upon the determination that the at least one part is in the abnormal state, control the measuring device to stop providing feedback to the component mounting device,
wherein the abnormal state indicates that the at least one part does not satisfy predetermined criteria.

2. The device of claim 1, wherein the at least one processor is further configured to control the measuring device to resume feedback in response to a signal indicating that the at least one part determined to be in the abnormal state is repaired.

3. The device of claim 1, wherein the at least one processor is further configured to transmit, to a user terminal, display information that enables a dashboard visualizing states of the plurality of parts to be displayed on the user terminal.

4. The device of claim 3, wherein the display information includes information about the at least one part, among the plurality of parts, which is determined to be in the abnormal state.

5. The device of claim 1, wherein the at least one processor is further configured to:
determine, based on the first mounting result information, an offset between a mounted state of the target component mounted on the target substrate and predetermined mounting criteria; and
determine, based on the offset and the hierarchical relationship, that the at least one part is in the abnormal state.

6. The device of claim 5, wherein the offset includes at least one of a position offset between a mounting position of the target component and a mounting position indicated by the mounting criteria, and an angle offset between a mounting angle of the target component and a mounting angle indicated by the mounting criteria.

7. The device of claim 5, wherein the at least one processor is further configured to:
obtain second mounting result information resulting from measuring a state in which components of the same type as the target component are mounted on each of a plurality of substrates having a layout identical to a layout of the target substrate;
determine, based on the second mounting result information, respective offsets of the components of the same type mounted on the plurality of substrates; and
determine, based on an average of the offset of the target component and the respective offsets of the components of the same type, that the at least one part is in the abnormal state.

8. The device of claim 5, wherein the at least one processor is further configured to:
obtain second mounting result information resulting from measuring a state in which components of the same type as the target component are mounted on each of a plurality of substrates having a layout identical to a layout of the target substrate;
determine, based on the second mounting result information, respective offsets of the components of the same type mounted on the plurality of substrates; and
determine, based on a variance of the offset of the target component and the respective offsets of the components of the same type, that the at least one part is in the abnormal state.

9. The device of claim 5, wherein the at least one processor is further configured to:
obtain third mounting result information resulting from measuring a state in which a first component and a second component distinct from the first component are mounted on the target substrate, the first component and the second component being mounted by one target part of the component mounting device;
determine, based on the third mounting result information, an offset of the first component and an offset of the second component; and
determine that the target part is in an abnormal state, based on the determination that the offset of the first component corresponds to the offset of the second component.

10. The device of claim 1, wherein the at least one memory is further configured to store a machine learning model trained on a correlation between mounting result information and abnormal states of parts, and
the at least one processor is further configured to determine, based on the machine learning model, that the at least one part is in the abnormal state.

11. A method performed by a device, the method comprising:
obtaining, from a measuring device, first mounting result information resulting from measuring a state in which a component mounting device has mounted a target component on a target substrate, the component mounting device includes a plurality of parts having a hierarchical relationship;
determining whether at least one part of the plurality of parts is in an abnormal state based on the first mounting result information and the hierarchical relationship; and
upon the determination that the at least one part is in the abnormal state, controlling the measuring device to stop providing feedback to the component mounting device,
wherein the abnormal state indicates that the at least one part does not satisfy predetermined criteria.

12. The method of claim 11, further comprising controlling the measuring device to resume feedback in response to a signal indicating that the at least one part determined to be in the abnormal state is repaired.

13. The method of claim 11, further comprising transmitting, to a user terminal, display information that enables a dashboard visualizing states of the plurality of parts to be displayed on the user terminal.

14. The method of claim 13, wherein the display information includes information about a part, among the plurality of parts, which is determined to be in the abnormal state.

15. The method of claim 11, wherein the determining of the at least one part to be in the abnormal state comprises:
determining, based on the first mounting result information, an offset between a mounted state of the target component mounted on the target substrate and predetermined mounting criteria; and
determining, based on the offset and the hierarchical relationship, that the at least one part is in the abnormal state.

16. The method of claim 15, wherein the obtaining of the first mounting result information comprises obtaining second mounting result information resulting from measuring a state in which components of the same type as the target component are mounted on each of a plurality of substrates having a layout identical to a layout of the target substrate,
wherein the determining of the offset of the target component, based on the first mounting result information comprises determining, based on the second mounting result information, respective offsets of the components of the same type mounted on the plurality of substrates, and
wherein the determining, based on the offset of the target component and the hierarchical relationship, that the at least one part is in the abnormal state comprises determining, based on an average of the offset of the target component and the respective offsets of the components of the same type, that the at least one part is in the abnormal state.

17. The method of claim 15, wherein the obtaining of the first mounting result information comprises obtaining second mounting result information resulting from measuring a state in which components of the same type as the target component are mounted on each of the plurality of substrates having a layout identical to a layout of the target substrate,
wherein the determining of the offset of the target component, based on the first mounting result information comprises determining, based on the second mounting result information, respective offsets of the components of the same type mounted on the plurality of substrates, and
wherein the determining, based on the offset of the target component and the hierarchical relationship, that the at least one part is in the abnormal state comprises determining, based on a variance of the offset of the target component and the respective offsets of the components of the same type, that the at least one part is in the abnormal state.

18. The method of claim 15, wherein the obtaining of the first mounting result information comprises obtaining third mounting result information resulting from measuring a state in which a first component and a second component distinct from the first component are mounted on the target substrate, the first component and the second component being mounted by one target part of the component mounting device,
wherein the determining of the offset of the target component, based on the first mounting result information comprises determining an offset of the first component and an offset of the second component based on the third mounting result information, and
wherein the determining, based on the offset of the target component and the hierarchical relationship, that the at least one part is in the abnormal state comprises determining that the target part is in an abnormal state, based on the determination that the offset of the first component corresponds to the offset of the second component.

19. The method of claim 11, wherein the determining of the at least one part to be in the abnormal state comprises determining that the at least one part is in the abnormal state, based on a machine learning model trained on a correlation between mounting result information and abnormal states of parts.

20. A non-transitory computer-readable recording medium recording a computer program to be executed by a processor, wherein the computer program is configured to, when executed by the processor, cause the processor to perform the method according to one of claims 11 to 19.
